# EUROPÄISCHE PATENTANMELDUNG

(11) **EP 3 945 563 A1**
(43) Veröffentlichungstag der Anmeldung: **02.02.2022**
(21) Anmeldenummer: 21176401.4
(22) Anmeldetag: 28.05.2021
(51) Int. Cl.: H01L 23/34, B60L 5/00

(54) **STRASSENFAHRZEUG**

(30) Priorität: 28.07.2020 DE 102020209483
(71) Anmelder: Siemens Mobility GmbH, 81739 München (DE)
(72) Erfinder: Dietrich, Klaus, 15537 Grünheide (Mark) OT Hangelsberg (DE); Molthan, Helge, 83075 Bad Feilnbach (DE)

(57) **Zusammenfassung**

Die Erfindung betrifft ein Straßenfahrzeug (1), welches einen von einem nicht geerdeten Fahrzeugrahmen (2) getragenen, elektrischen oder hybridelektrischen Traktionsantrieb (3), einen Stromabnehmer (6) zur Kontaktierung von Fahrdrähten (5) einer geerdeten Oberleitungsanlage (4) und eine zwischen Stromabnehmer (6) und Traktionsantrieb (3) geschaltete leistungselektronische Halbleiterkomponente (8) umfasst. Erfindungsgemäß umfasst das Straßenfahrzeug (1) ferner ein Kühlsystem (9) zur Abfuhr von im Betrieb der Halbleiterkomponente (8) entstehender Wärme, welches einen von einem Kühlmittel (10) durchströmbaren Kühlkörper (11) umfasst. Der Kühlkörper (11) ist zum Wärmetausch mit der Halbleiterkomponente (8) thermisch gekoppelt, mit dem Fahrzeugrahmen (2) elektrisch leitend verbunden und weist eine doppelte elektrische Isolierung zwischen einem elektrischen Oberleitungspotenzial der Halbleiterkomponente (8) und einem elektrischen Rahmenpotenzial des Fahrzeugrahmens (2) auf. Hierdurch wird die elektrische Betriebssicherheit des Straßenfahrzeugs (1) verbessert.

## Beschreibung

Die Erfindung betrifft ein Straßenfahrzeug nach dem Oberbegriff des Patentanspruches 1.

Ein derartiges Straßenfahrzeug ist aus der internationalen Veröffentlichung WO 2015/049161 A1 bekannt und umfasst einen von einem nicht geerdeten Fahrzeugrahmen getragenen, elektrischen oder hybridelektrischen Traktionsantrieb. Ferner umfasst es einen Stromabnehmer zur Kontaktierung von Fahrdrähten einer geerdeten Oberleitungsanlage. Zwischen dem Stromabnehmer und dem Traktionsantrieb sind leistungselektronische Halbleiterkomponenten, wie Gleichspannungswandler oder Wechselrichter geschaltet.

Aufgrund des isolierten Aufstandes des Fahrzeugs auf Erde über gummibereifte Räder ist der Fahrzeugrahmen nicht geerdet. Damit es bei hergestelltem galvanischen Kontakt zwischen den Fahrdrähten der geerdeten Oberleitungsanlage und dem Stromabnehmer und damit dem Traktionsantrieb nicht zu gefährlichen Berührungsspannungen am Fahrzeugrahmen kommen kann, muss ein Schutzsystem des Fahrzeugs eine elektrische Trennung zwischen den leitend mit Stromabnehmer und Traktionsantrieb verbindbaren Fahrzeugteilen und den leitend mit dem Fahrzeugrahmen verbundenen Fahrzeugteilen bewerkstelligen. Das Schutzsystem sieht eine einfache Isolationsschicht am Traktionsantrieb, einem Energiespeicher und einem dem Traktionsantrieb vorgeschalteter Wechselrichter vor. Zusätzlich ist der Gleichspannungswandlung galvanisch trennend ausgebildet, der mittels eines Schaltelementes wahlweise zuschaltbar oder überbrückbar ist. Stromabnehmer, Gleichspannungswandler und Überbrückungsleiter gehören zu einem Bereich mit doppelter Isolationsschicht.

Die Erfindung liegt die Aufgabe zugrunde, ein Straßenfahrzeug der eingangs genannten Art derart weiterzubilden, dass die elektrische Betriebssicherheit verbessert wird.

Die Aufgabe wird gelöst durch ein gattungsgemäßes Straßenfahrzeug mit den im kennzeichnenden Teil des Patentanspruches 1 angegebenen Merkmalen.

Demnach umfasst das Straßenfahrzeug einen von einem nicht geerdeten Fahrzeugrahmen getragenen, elektrischen oder hybridelektrischen Traktionsantrieb. Der Traktionsantrieb weist einen Elektromotor auf, dessen Traktionsenergie mittels eines Stromabnehmers des Straßenfahrzeugs aus einer geerdeten Oberleitungsanlage einspeisbar ist. Alternativ beziehungsweise zusätzlich kann die Traktionsenergie aus einem fahrzeugseitigen Energiespeicher bezogen oder durch einen vorgeschalteten Dieselgenerator erzeugt werden. Der Stromabnehmer kann als aufrichtbarer Pantograph zur Kontaktierung von Fahrdrähten der Oberleitungsanlage ausgebildet sein. Zwischen Stromabnehmer und Traktionsantrieb sind ein oder mehrere leistungselektronische Halbleiterkomponenten geschaltet, die beispielsweise als Gleichspannungswandler oder Wechselrichter ausgebildet sein können. Erfindungsgemäß umfasst das Straßenfahrzeug ein Kühlsystem, welches zur Abfuhr von im Betrieb einer Halbleiterkomponente entstehender Wärme vorgesehen und ausgebildet ist. Dazu umfasst das Kühlsystem einen von einem Kühlmittel durchströmbaren Kühlkörper. Der Kühlkörper ist zum Wärmetausch mit der Halbleiterkomponente thermisch gekoppelt, so dass vom Kühlkörper aufgenommene Wärme durch den Kühlmittelstrom abtransportierbar ist. Der Kühlkörper ist mit dem Fahrzeugrahmen elektrisch leitend verbunden, weist aber als elektrisches Schutzsystem eine doppelte elektrische Isolierung zwischen einem elektrischen Oberleitungspotenzial der Halbleiterkomponente und einem elektrischen Rahmenpotenzial des Fahrzeugrahmens auf. Damit wird der Isolationswert des Schutzsystems nicht durch das Kühlsystem für eine Halbleiterkomponente beeinträchtigt, was die elektrische Betriebssicherheit eines erfindungsgemäßen Straßenfahrzeugs erhöht.

Durch die erfindungsgemäße Lösung kann insbesondere ein separater Kühlkreislauf für Halbleiterkomponenten, die mit anderen als dem Oberleitungspotenzial verbunden sind, vermieden werden, der erforderlich wäre, um das Oberleitungspotenzial im Fehlerfall nicht durch das leitfähige Kühlmittel in andere Potenzialebenen zu verschleppen. Dadurch spart die erfindungsgemäße Lösung demgegenüber erheblich an Zusatzkosten und Zusatzgewicht für einen zweiten, separaten Kühlkreislauf ein.

In einer vorteilhaften Ausführungsform des erfindungsgemäßen Straßenfahrzeugs weist das Kühlsystem einen Leitungskreis für das Kühlmittel auf, der durch den Kühlkörper, durch einen Rückkühler zum Abkühlen des Kühlmittels und durch eine Kühlmittelpumpe zum Fördern des Kühlmittels geführt ist. Die Kühlmittelpumpe wälzt das Kühlmittel im Leitungskreis um, so dass vom Kühlkörper ausströmendes, aufgeheiztes Kühlmittel Wärme beim anschließenden Durchströmen des Rückkühlers wieder abgeben kann.

In einer weiteren vorteilhaften Ausführungsform des erfindungsgemäßen Straßenfahrzeugs ist das Kühlmittel elektrisch leitfähig ausgebildet. Dessen vorteilhafter Einsatz wird durch die doppelte Isolierung möglich, welche bei einem kombinierten Kühlsystem sonst nur mit einem isolierenden Kühlmittel realisierbar wäre, welches dauerhaft zuverlässige Isoliereigenschaften haben muss. Solche Kühlmittel, die typischerweise ölbasiert sind, weisen schlechtere Wärmeleiteigenschaften und geringere Wärmekapazitäten auf als wasserbasierte Kühlmittel. Das Kühlsystems müsste dann mit größeren Kühlflächen und höheren Querschnitten für einen höheren Kühlmitteldurchsatz ausgelegt werden. Durch die doppelte Isolierung kann ein kostengünstiges wasserbasiertes Kühlmittel verwendet werden.

In einer weiteren vorteilhaften Ausführungsform des erfindungsgemäßen Straßenfahrzeugs ist die doppelte elektrische Isolierung durch eine erste elektrische Isolationsschicht und eine zweite elektrische Isolationsschicht gebildet, welche zwischen Kühlkörper und Halbleiterkomponente angeordnet und kongruent ausgebildet sind. Die zwei Isolationsschichten sind auf einer der Halbleiterkomponente zugewandten Außenfläche des Kühlkörpers aufgebracht und sind im Wesentlichen deckungsgleich. Der höhere Wärmeübergangswiderstand der zwei Isolationsschichten sind im Gegensatz zu den schlechteren Kühleigenschaften eines isolierenden Kühlmittels weniger nachteilig. Die Integration der doppelten Isolierung innerhalb des Kühlkörpers kann kosten-, platz- und gewichtssparender realisiert werden als der Einbau eines separaten Kühlkreislaufes.

In einer weiteren vorteilhaften Ausführungsform des erfindungsgemäßen Straßenfahrzeugs ist zwischen der ersten elektrischen Isolationsschicht und der zweiten elektrischen Isolationsschicht eine leitfähige Zwischenschicht angeordnet und mit einem Messgerät zum Erfassen eines elektrischen Zwischenpotenzials der Zwischenschicht verbunden. Der Isolationswert der doppelten Isolierung muss mindestens einmal täglich geprüft werden und darf 500 Ω/V der Nennspannung nicht unterschreiten. Die dazwischenliegende leitfähige Schicht ermöglicht die geforderte Prüfmöglichkeit für beide Isolationsschichten separat. Die Überwachungsmöglichkeit ist insbesondere einfacher und stellt einen langfristigeren Betrieb sicher, als dies bei Verwendung von isolierenden Kühlmitteln der Fall wäre.

In einer alternativen vorteilhaften Ausführungsform des erfindungsgemäßen Straßenfahrzeugs ist die doppelte elektrische Isolierung durch eine erste elektrische Isolationsschicht, welche zwischen Kühlkörper und Halbleiterkomponente angeordnet ist, und eine zweite elektrische Isolationsschicht, mit welcher die Innenwand des Leitungskreises ausgekleidet ist, gebildet. In diesem Fall entfallen die leitfähige Zwischenschicht und die zweite, zur ersten kongruente Isolationsschicht. Der Kühlkörper liegt auf dem Zwischenpotenzial und muss isoliert vom Fahrzeugrahmen befestigt werden. Die zweite Isolationsschicht kann beispielsweise durch eine isolierende Beschichtung der mit dem Kühlmittel benetzten Innenflächen des Kühlkörpers gebildet werden.

In einer weiteren vorteilhaften Ausführungsform umfasst das erfindungsgemäße Straßenfahrzeug eine weitere leistungselektronische Halbleiterkomponente, die nicht mit dem Oberleitungspotenzial verbindbar ist, sondern auf einem Zwischenpotenzial liegt. Dabei umfasst das Kühlsystem zur Abfuhr von im Betrieb der weiteren Halbleiterkomponente entstehender Wärme einen vom Kühlmittel durchströmbaren weiteren Kühlkörper, welcher zum Wärmetausch mit der weiteren Halbleiterkomponente thermisch gekoppelt ist, mit dem Fahrzeugrahmen elektrisch leitend verbunden ist und eine elektrische Isolationsschicht zwischen dem elektrischen Zwischenpotenzial der weiteren Halbleiterkomponente und dem auf elektrischem Rahmenpotenzial des Fahrzeugrahmens liegenden Kühlkörper aufweist. Hierdurch können bei oberleitungsgespeisten Straßenfahrzeugen mit einem gemeinsamen wasserbasierten Kühlkreislauf die Wärme von Halbleiterkomponenten auf unterschiedlichen Isolationsebenen abgeführt werden, also sowohl von auf Oberleitungspotenzial liegenden Halbleiterkomponenten als auch von auf Zwischenpotenzial liegenden Halbleiterkomponenten.

Weitere Eigenschaften und Vorteile ergeben sich aus nachfolgender Beschreibung eines Ausführungsbeispiels anhand der Zeichnungen, in deren
- FIG 1: ein erfindungsgemäßes Straßenfahrzeug in Seitenan sicht und
- FIG 2: das Kühlsystem des Straßenfahrzeugs aus FIG 1
schematisch veranschaulicht sind.

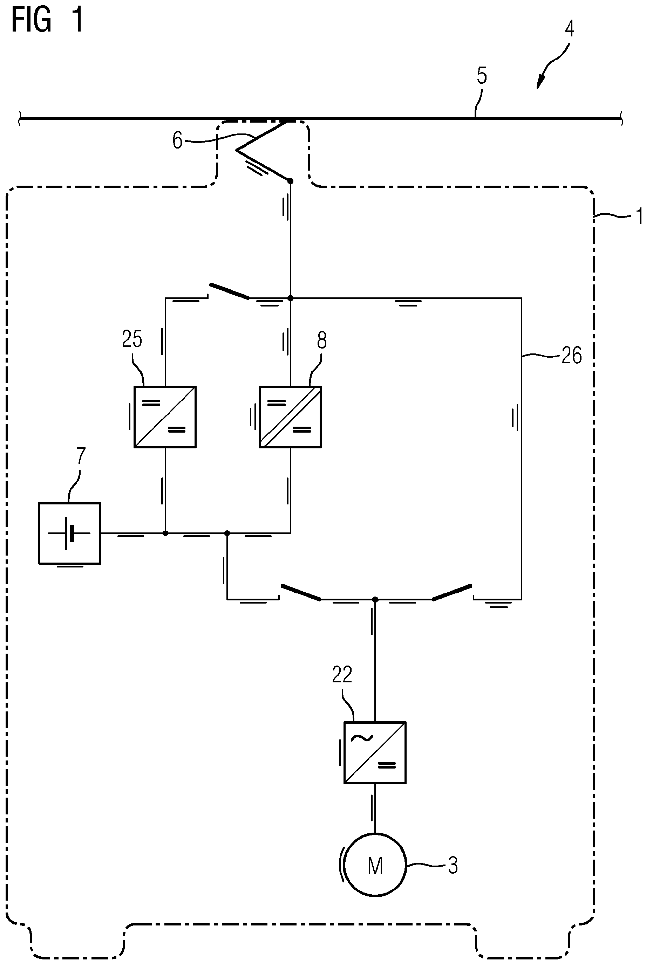

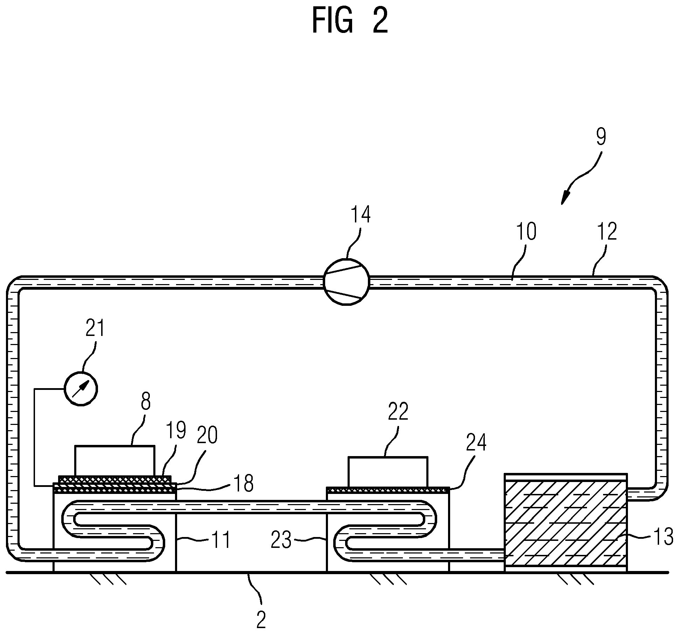

Gemäß FIG 1 sind von dem erfindungsgemäßen Straßenfahrzeug 1, das beispielsweise ein schweres Nutzfahrzeug sein kann, an sich bekannte Teile, wie etwa ein Fahrzeugrahmen 2 (vgl. FIG 2), welcher Radachsen mit gummibereiften Rädern, eine Fahrerkabine sowie einen Fahrzeugaufbau zum Transport von Gütern trägt, nicht dargestellt. Der Fahrzeugrahmen 2 trägt ferner einen Traktionsantrieb 3, der rein elektrisch oder hybridelektrisch ausgebildet sein kann und dessen Drehmoment über ein ebenfalls nicht dargestelltes Getriebe auf Räder übertragbar ist. Für Streckenabschnitte mit einer zweipoligen Oberleitungsanlage 4, von welcher in FIG 1 zwei über der Fahrbahn hängende und als Hin- und Rückleiter ausgebildete Fahrdrähte 5 durch eine gemeinsame Linie dargestellt sind, umfasst das Fahrzeug 1 einen Stromabnehmer 6 zur externen Einspeisung von Traktionsenergie. Der Stromabnehmer 6 kann ein anheb- und absenkbares, pantographenartiges Gestell aufweisen, welches zwei Wippen mit Schleifleisten trägt. Mittels der Schleifleisten des Stromabnehmer 6 wird ein galvanischer Kontakt zu den Fahrdrähten 5 hergestellt, um Traktionsenergie in das Straßenfahrzeug 1 einzuspeisen oder um Bremsenergie rückzuspeisen. Bei unterbrochenem galvanischem Kontakt oder auf Streckenabschnitten ohne Oberleitungsanlage 4 kann der hybridelektrische Traktionsantrieb 3 beispielsweise über ein Dieselaggregat oder aus einem fahrzeugseitigen Energiespeicher 7, beispielsweise elektrischen Doppelschichtkondensatoren und/oder Nickel-Metall-Hydrid-Batterien, mit Traktionsenergie versorgt werden.

Das Straßenfahrzeug 1 weist ein elektrisches Schutzsystem zur Vermeidung von gefährlichen Berührungsspannungen am Fahrzeugrahmen 2 oder an damit elektrisch leitend verbundenen Fahrzeugteilen auf. Aufgrund des isolierten Aufstandes des Straßenfahrzeugs 1 auf Erde über gummibereifte Räder ist der Fahrzeugrahmen 2 nicht geerdet. Das Schutzsystem sieht eine elektrische Trennung beziehungsweise Isolation zwischen den leitend mit dem Stromabnehmer 6 verbindbaren Fahrzeugteilen, die dann auf einem elektrischen Oberleitungspotenzial liegen, und den leitend mit dem Fahrzeugrahmen 2 verbundenen Fahrzeugteilen, die auf einem elektrischen Rahmenpotenzial liegen, vor. Bei einem Versagen des Schutzsystems kann es bei einem Körperschluss zum Fahrzeugrahmen 2 durch eine auf Erde stehende und das Straßenfahrzeug 1 von außen berührende Person zu lebensbedrohenden Körperströmen kommen.

Zu einem Bereich mit elektrisch einfacher Isolierung - in FIG 1 durch einfache Beistriche veranschaulicht - gehören der Traktionsantrieb 3, der Energiespeicher 7 sowie ein dem Traktionsantrieb 3 vorgeschalteter Wechselrichter 22 zur Umwandlung von Gleich- in Wechselspannung. Zu einem Bereich mit elektrisch doppelter Isolierung - in FIG 1 durch zweifache Beistriche veranschaulicht - gehören der Stromabnehmer 6 sowie ein zwischen Stromabnehmer 6 und Traktionsantrieb 3 geschalteter, galvanisch trennender Gleichspannungswandler 8. Der Stromabnehmer 6 ist alternativ über einen parallel geschalteten galvanisch nicht trennenden Gleichspannungswandler 25 mit dem Energiespeicher 7 oder dem Traktionsantrieb 3 oder ebenfalls parallel über einen Überbrückungsleiter 26 durch verschiedene Schaltelemente verbindbar.

Bei den Gleichspannungswandlern 8 und 25 und dem Wechselrichter 22 handelt es sich um leistungselektronische Halbleiterkomponenten, die im Betrieb Wärme erzeugen, welche durch ein in FIG 2 dargestelltes Kühlsystem 9 abzuführen ist, ohne dass das elektrische Schutzsystem geschwächt werden darf.

Gemäß FIG 2 umfasst das Kühlsystem 9 einen gemeinsamen Kühlkreislauf für auf Oberleitungspotenzial liegende Halbleiterkomponenten 8, wie den Gleichspannungswandler, und für auf Zwischenpotenzial liegende, weitere Halbleiterkomponenten 22, wie den Wechselrichter. Das Kühlsystem 9 umfasst einen Kühlkörper 11, der zum Wärmetausch mit der Halbleiterkomponente 8 thermisch gekoppelt ist, und einen weiteren Kühlkörper 23, der zum Wärmetausch mit der weiteren Halbleiterkomponente 22 thermisch gekoppelt ist. Das Kühlsystem 9 umfasst einen Leitungskreis 12, in dem elektrisch leitfähiges Kühlmittel 10 durch eine Kühlmittelpumpe 14 umgewälzt wird. Das Kühlmittel 10 kann wasserbasiert sein. Das Kühlsystem 9 umfasst schließlich einen Rückkühler 13 zum Abkühlen des nach Durchströmen der Kühlkörper 11 und 23 aufgeheizten Kühlmittels 10. Der Kühlkörper 11, der weitere Kühlkörper 23 und der Rückkühler 13 sind elektrisch leitend mit dem Fahrzeugrahmen 2 verbunden und liegen daher elektrisch auf Rahmenpotenzial. Da die weitere Halbleiterkomponente 22 elektrisch auf Zwischenpotenzial liegt, genügt eine einfache elektrische Isolation, die durch eine elektrische Isolationsschicht 24 gebildet ist. Die mit Oberleitungspotenzial verbindbare Halbleiterkomponente 8 hingegen weist eine doppelte Isolierung gegen ihren Kühlkörper 11 auf. Diese wird durch eine erste elektrische Isolationsschicht 18 und durch eine zweite elektrische Isolationsschicht 19 gebildet, die im Wesentlichen kongruent ausgebildet sind. Zwischen der ersten und der zweiten elektrischen Isolationsschicht 18 und 19 ist eine elektrisch leitfähige Zwischenschicht 20 angeordnet, die eine Überprüfung des Isolationswiderstands jeder der Isolationsschichten 18 und 19 erlauben. Hierzu ist die Zwischenschicht 20 mit einem Messgerät 21 zum Erfassen des elektrischen Zwischenpotenzial der Zwischenschicht 20 verbunden. Der Isolationswert der doppelten Isolierung wird regelmäßig geprüft werden und darf 500 Ω/V der Nennspannung nicht unterschreiten.

Hierdurch ist ein kosten-, platz- und gewichtssparendes Kühlsystem 9 durch einen gemeinsamen Kühlkreislauf unter Verwendung eines wasserbasierten Kühlmittels 10. Trotz Verwendung eines leitfähigen Kühlmittels 10 kann dieses Oberleitungspotenzial im Fehlerfall nicht in andere Potenzialebenen verschleppen. Das wasserbasierte Kühlmittel 10 weist bessere Wärmeleiteigenschaften und höhere Wärmekapazitäten auf als ölbasierte Kühlmittel. Insgesamt wird die elektrische Betriebsfestigkeit eines oberleitungsgespeisten Straßenfahrzeugs 1 erhöht.

## Patentansprüche

1. Straßenfahrzeug (1), umfassend
- einen von einem nicht geerdeten Fahrzeugrahmen (2) getragenen, elektrischen oder hybridelektrischen Traktionsantrieb (3),
- einen Stromabnehmer (6) zur Kontaktierung von Fahrdrähten (5) einer geerdeten Oberleitungsanlage (4) und
- eine zwischen Stromabnehmer (6) und Traktionsantrieb (3) geschaltete leistungselektronische Halbleiterkomponente (8), **gekennzeichnet durch** ein Kühlsystem (9) zur Abfuhr von im Betrieb der Halbleiterkomponente (8) entstehender Wärme, welches einen von einem Kühlmittel (10) durchströmbaren Kühlkörper (11) umfasst, welcher
- zum Wärmetausch mit der Halbleiterkomponente (8) thermisch gekoppelt ist,
- mit dem Fahrzeugrahmen (2) elektrisch leitend verbunden ist und
- eine doppelte elektrische Isolierung zwischen einem elektrischen Oberleitungspotenzial der Halbleiterkomponente (8) und einem elektrischen Rahmenpotenzial des Fahrzeugrahmens (2) aufweist.

2. Straßenfahrzeug (1) nach Anspruch 1,
- wobei das Kühlsystem (9) einen Leitungskreis (12) für das Kühlmittel (10) aufweist, der durch den Kühlkörper (11), durch einen Rückkühler (13) zum Abkühlen des Kühlmittels (10) und durch eine Kühlmittelpumpe (14) zum Fördern des Kühlmittels (10) geführt ist.

3. Straßenfahrzeug (1) nach Anspruch 1 oder 2,
- wobei das Kühlmittel (10) elektrisch leitfähig ausgebildet ist.

4. Straßenfahrzeug (1) nach einem der Ansprüche 1 bis 3,
- wobei die doppelte elektrische Isolierung durch eine erste elektrische Isolationsschicht (18) und eine zweite elektrische Isolationsschicht (19) gebildet ist, welche zwischen Kühlkörper (11) und Halbleiterkomponente (8) angeordnet und kongruent ausgebildet sind.

5. Straßenfahrzeug (1) nach Anspruch 4,
- wobei zwischen der ersten elektrischen Isolationsschicht (18) und der zweiten elektrischen Isolationsschicht (19) eine leitfähige Zwischenschicht (20) angeordnet und mit einem Messgerät (21) zum Erfassen eines elektrischen Zwischenpotenzials der Zwischenschicht (20) verbunden ist.

6. Straßenfahrzeug (1) nach Anspruch 1 bis 3,
- wobei die doppelte elektrische Isolierung durch eine erste elektrische Isolierschicht, welche zwischen Kühlkörper (11) und Halbleiterkomponente (8) angeordnet ist, und eine zweite elektrische Isolierschicht, mit welcher die Innenwand des Leitungskreises (12) ausgekleidet ist, gebildet ist.

7. Straßenfahrzeug (1) nach einem der Ansprüche 1 bis 6, umfassend
- eine weitere leistungselektronische Halbleiterkomponente (22), die nicht mit dem Oberleitungspotenzial verbindbar ist, sondern auf einem Zwischenpotenzial liegt,
- wobei das Kühlsystem (9) zur Abfuhr von im Betrieb der weiteren Halbleiterkomponente (22) entstehender Wärme einen vom Kühlmittel (10) durchströmbaren weiteren Kühlkörper (23) umfasst, welcher
- zum Wärmetausch mit der weiteren Halbleiterkomponente (22) thermisch gekoppelt ist,
- mit dem Fahrzeugrahmen (2) elektrisch leitend verbunden ist und
- eine elektrische Isolationsschicht (24) zwischen dem elektrischen Zwischenpotenzial der weiteren Halbleiterkomponente (22) und dem auf elektrischem Rahmenpotenzial des Fahrzeugrahmens (2) liegenden, weiteren Kühlkörper (23) aufweist.
